# EUROPEAN PATENT APPLICATION

(11) **EP 2 410 568 A2**
(43) Date of publication of application: **25.01.2012**
(21) Application number: 11154459.9
(22) Date of filing: 15.02.2011
(51) Int. Cl.: H01L 27/142, H01L 31/0224

(54) **Solar cell and method for manufacturing the same**

(30) Priority: 19.07.2010 KR 20100069495
(71) Applicant: SAMSUNG ELECTRONICS CO., LTD., Yeongtong-gu Suwon-city Gyeonggi-do 442-742 (KR); SAMSUNG SDI CO., LTD., Yongin-si, Gyeonggi-do (KR)
(72) Inventor: Kim, Young Su, Seoul (KR); Mo, Chan Bin, Gyeonggi-do (KR)
(74) Representative: Taor, Simon Edward William

(57) **Abstract**

A method for manufacturing a solar cell includes disposing a first doping layer on a substrate, disposing a diffusion preventing layer on the first doping layer, patterning the first doping layer and the diffusion preventing layer to expose a portion of the substrate, forming a second doping layer which is disposed on the exposed portion of the substrate on the diffusion preventing layer, diffusing an impurity from the first doping layer to form a first doping region in a surface of the substrate and diffusing an impurity from the second doping layer to form a second doping region in the surface of the substrate surface, wherein the exposed portion of the substrate formed by patterning the first doping layer and the diffusion preventing layer and a portion of the remaining first doping layer and the diffusion preventing layer which are not patterned are alternately arranged with a lattice shape, and the first doping region and the second doping region are alternately arranged with the lattice shape.

## Description

### BACKGROUND OF THE INVENTION

### (a) Field of the Invention

The present invention generally relates to a solar cell and a manufacturing method thereof.

### (b) Description of the Related Art

A solar cell is a device that converts photonic energy, e.g., solar light energy, into electrical energy using a photoelectric effect.

It is important to produce clean energy, also referred to as next-generation energy, that can replace existing fossil fuel energy, that causes a greenhouse effect due to carbon dioxide (CO2) discharge and atomic energy, that pollutes the earth environment such as via atmospheric pollution by radioactive waste, for example.

A basic structure of a solar cell typically has a conjunction structure of a P-type semiconductor and an N-type semiconductor, such as a diode, and if light is absorbed in the solar cell, electrons having a negative (-) charge and holes having a positive (+) charge caused by the removal of the electrons are generated by interaction of the light and a material that constitutes a semiconductor of the solar cell, such that a current flows while the electrons and holes move through the solar cell.

This phenomenon is called a photovoltaic effect. In the P-type and N-type semiconductors that constitute the solar cell, the electrons are drawn to the N-type semiconductor and the holes are drawn to the P-type semiconductor such that they move to electrodes that are connected to the N-type semiconductor and the P-type semiconductor, respectively, and if the electrodes are connected to wires, a current flows through the electrodes and the wires, thereby generating electric power.

In a back contact solar cell, which is one of the different possible structures of the solar cell, all of a P-type semiconductor, an N-type semiconductor, and metal grids that are connected thereto are disposed in a rear side of the solar cell where a front side of the solar cell absorbs incident light.

In order to maximize efficiency of a solar cell, research has been conducted to minimize a distance that carriers such as electrons or holes generated by light move to reach an N-type semiconductor or a P-type semiconductor.

### BRIEF SUMMARY OF THE INVENTION

Exemplary embodiments according to the present invention provide a solar cell and a manufacturing method thereof that increase an efficiency of the solar cell by minimizing a moving distance of carriers.

An exemplary embodiment of a solar cell according to the present invention includes a substrate; a first doping region and a second doping region positioned in a surface of the substrate; and a passivation layer disposed on the first doping region and the second doping region, wherein the first doping region and the second doping region are alternately arranged in a grid pattern.

In one embodiment, a first electrode and a second electrode disposed on the passivation layer may be further included.

In one embodiment, the passivation layer may include a plurality of first contact holes and a plurality of second contact holes, the first electrode and the first doping region may be connected to each other through the plurality of first contact holes, and the second electrode and the second doping region may be connected to each other through the plurality of second contact holes.

In one embodiment, the first doping region and the second doping region may be alternately arranged according to a first direction and a second direction where the first direction and the second direction are substantially perpendicular to each other.

In one embodiment, the first electrode may extend with a straight line shape along a third direction, and the third direction may form an angle of about 45 degrees with at least one of the first direction or the second direction.

In one embodiment, the first electrode and the second electrode may respectively include a portion extending with a zigzag shape.

In one embodiment, the first doping region and the second doping region may have a quadrangle shape in a plane view.

In one embodiment, the substrate may include a front side and a back side, and the first doping region and the second doping region may be formed to be disposed in the back side of the substrate.

In one embodiment, light may be absorbed through the front side of the substrate.

In one embodiment, the first doping region and the second doping region may include different conductive type of impurities.

An exemplary embodiment of manufacturing method of a solar cell according to the present invention includes forming a first doping layer on a substrate; forming a diffusion preventing layer on the first doping layer; patterning the first doping layer and the diffusion preventing layer to expose a portion of the substrate; forming a second doping layer disposed on the exposed substrate on the diffusion preventing layer; diffusing an impurity from the first doping layer to form a first doping region in the surface of the substrate; and diffusing an impurity from the second doping layer to form a second doping region in the surface of the substrate surface, wherein the exposed portion of the substrate formed by patterning the first doping layer and the diffusion preventing layer and the remaining portion of the first doping layer and the diffusion preventing layer that are not patterned are alternately arranged with a lattice shape, and the first doping region and the second doping region are alternately arranged with the lattice shape.

In one embodiment, the diffusion of the impurity to form the first doping region and the second doping region may be executed through heat treatment.

In one embodiment, the substrate may include a front side and a back side, and the first doping region and the second doping region may be formed on the back side of the substrate.

The exemplary embodiment of the method may further include removing the first doping layer, the diffusion preventing layer, and the second doping layer; forming a passivation layer having a plurality of first contact holes and a plurality of second contact holes on the back side of the substrate; and forming a first electrode and a second electrode on the passivation layer, wherein the first electrode and the first doping region may be connected to each other through the plurality of first contact holes, and the second electrode and the second doping region may be connected to each other through the plurality of second contact holes.

In one embodiment, the first doping region and the second doping region may be alternately formed according to a first direction and a second direction, and the first direction and the second direction may be crossed.

In one embodiment, the first electrode may extend with a straight line shape along the third direction, and the third direction may form substantially an angle of 45 degrees with at least one of the first direction or the second direction.

In one embodiment, the first electrode and the second electrode may include a portion extending with a zigzag shape.

Another exemplary embodiment of a manufacturing method of a solar cell according to the present invention includes forming a first doping layer on a substrate; forming a diffusion preventing layer on the first doping layer; patterning the first doping layer and the diffusion preventing layer to expose a portion of the substrate; injecting ions into the substrate using the first doping layer and the diffusion preventing layer as a mask; and diffusing an impurity from the first doping layer to form a first doping region in the surface of the substrate surface, wherein the first doping region forms a PN conjunction along with a second doping region formed in the surface of the substrate injected with the ions, a portion of the substrate exposed through patterning of the first doping layer and the diffusion preventing layer and a remaining portion of the first doping layer and the diffusion preventing layer that are not patterned are alternately arranged with a lattice shape, and the first doping region and the second doping region are alternately arranged with a lattice shape.

In one exemplary embodiment, the PN conjunction of the first doping region and the second doping region may be formed through a heat treatment process.

One exemplary embodiment of the method may further include removing the first doping layer, the diffusion preventing layer, and the second doping layer; forming a passivation layer having a plurality of first contact holes and a plurality of second contact holes on the back side of the substrate; and forming a first electrode and a second electrode on the passivation layer, wherein the first electrode and the first doping region may be connected to each other through the plurality of first contact holes, and the second electrode and the second doping region may be connected to each other through the plurality of second contact holes.

In one exemplary embodiment, the first doping region and the second doping region may be alternately formed according to a first direction and a second direction, and the first direction and the second direction may be crossed.

In one exemplary embodiment, the first electrode may extend with a straight line shape along the third direction, and the third direction may form substantially an angle of 45 degrees with at least one of the first direction or the second direction.

In one exemplary embodiment, the first electrode and the second electrode may include a portion extending with a zigzag shape.

### BRIEF DESCRIPTION OF THE DRAWINGS

The above and other aspects, advantages and features of this disclosure will become more apparent by describing in further detail embodiments thereof with reference to the accompanying drawings, in which:
FIG. 1 is a top plan view showing an exemplary embodiment of a pattern structure of a doping region in a solar cell according to the present invention;
FIG. 2 is a cross-sectional view taken along line II-II' of FIG. 1;
FIG. 3 is a top plan view of the exemplary embodiment of the solar cell shown in FIG.1 with an added electrode according to the present invention;
FIG. 4 is a cross-sectional view taken along line IV-IV' of FIG. 3;
FIGS. 5 and 6 are top plan views which compare moving distances of a charge-carrier according to a pattern structure of a doping region;
FIGS. 7 and 8 are band diagrams which compare an electric field operated to carriers according to a pattern structure of a doping region;
FIG. 9 is a top plan view showing another exemplary embodiment of an electrode structure in a solar cell according to the present invention;
FIG. 10 is a top plan view showing yet another exemplary embodiment of a pattern structure of a doping region in a solar cell according to the present invention; and
FIGS. 11 to 19 are plan views and cross-sectional views showing an exemplary embodiment of a manufacturing method of the exemplary embodiment of a solar cell shown in FIG. 1 according to the present invention.

### DETAILED DESCRIPTION OF THE INVENTION

The general inventive concept now will be described more fully hereinafter with reference to the accompanying drawings, in which various embodiments are shown. This invention may, however, be embodied in many different forms, and should not be construed as limited to the embodiments set forth herein. Rather, these embodiments are provided so that this disclosure will be thorough and complete, and will fully convey the scope of the invention to those skilled in the art. Like reference numerals refer to like elements throughout.

It will be understood that when an element is referred to as being "on" another element, it can be directly on the other element or intervening elements may be present therebetween. In contrast, when an element is referred to as being "directly on" another element, there are no intervening elements present. As used herein, the term "and/or" includes any and all combinations of one or more of the associated listed items.

It will be understood that, although the terms first, second, third etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, a first element, component, region, layer or section discussed below could be termed a second element, component, region, layer or section without departing from the teachings of the present invention.

The terminology used herein is for the purpose of describing particular embodiments only and is not intended to be limiting. As used herein, the singular forms "a," "an" and "the" are intended to include the plural forms as well, unless the context clearly indicates otherwise. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The exemplary term "lower," can therefore, encompasses both an orientation of "lower" and "upper," depending on the particular orientation of the figure. Similarly, if the device in one of the figures is turned over, elements described as "below" or "beneath" other elements would then be oriented "above" the other elements. The exemplary terms "below" or "beneath" can, therefore, encompass both an orientation of above and below.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

Hereinafter, embodiments of the present invention will be described in further detail with reference to the accompanying drawings.

Exemplary embodiments according to the present invention will be described more fully hereinafter with reference to the accompanying drawings, in which the exemplary embodiments of the invention are shown.

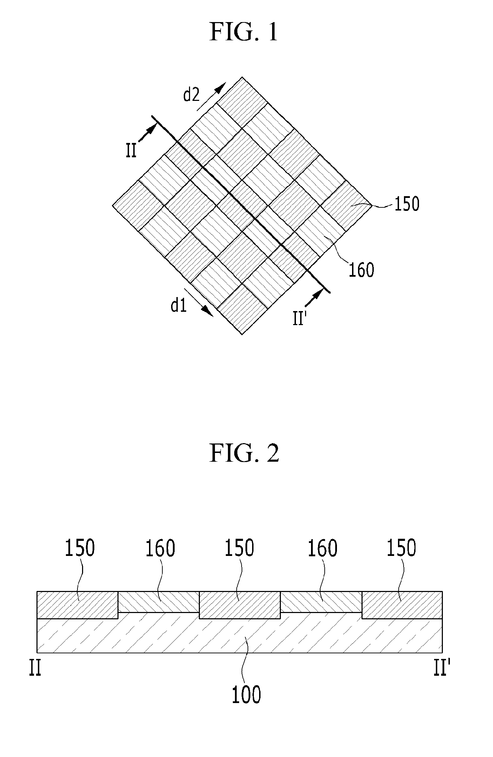

FIG. 1 is a top plan view showing an exemplary embodiment of a pattern structure of a doping region in a solar cell according to the present invention.

FIG. 2 is a cross-sectional view taken along line II-II' of FIG. 1.

Referring to FIGS. 1 and 2, a first doping region 150 and a second doping region 160 are disposed on a surface of a substrate 100.

In one exemplary embodiment, the substrate 100 may be an N-type silicon wafer.

In one exemplary embodiment, polarities of an impurity region and the doping regions of the exemplary embodiment may be changed to be applied to a P-type wafer.

The first doping region 150 and the second doping region 160 are alternately arranged with a grid pattern.

In detail, a first unit which refers to one first doping region 150 and one second doping region 160 that neighbor each other is repeatedly arranged along a second direction d2 as well as a first direction d1 where the first direction d1 and the second direction d2 are substantially perpendicular to each other.

In one exemplary embodiment, the first doping region 150 and the second doping region 160 may have a quadrangle shape in a viewpoint of a plane area, but not limited thereto, and may have various other shapes.

In an exemplary embodiment of the solar cell manufactured according to the present invention, the first doping region 150 and the second doping region 160 form a PN conjunction.

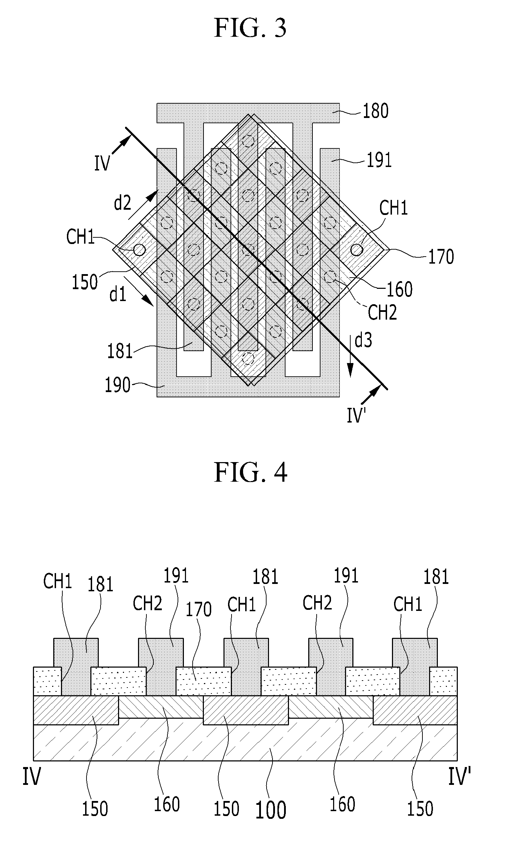

FIG. 3 is a top plan view of the exemplary embodiment of the solar cell of FIG. 1 including an added electrode according to the present invention.

FIG. 4 is a cross-sectional view taken along line IV-IV' of FIG. 3.

Referring to FIGS. 3 and 4, a passivation layer 170 disposed on the first doping region 150 and the second doping region 160 is disposed on the substrate 100.

The passivation layer 170 has a plurality of first contact holes CH1 and a plurality of second contact holes CH2.

The plurality of first contact holes CH1 is positioned corresponding to the first doping region 150, and the plurality of second contact holes CH2 is positioned corresponding to the second doping region 160.

A first electrode and a second electrode are disposed on the passivation layer 170.

The first electrode includes a first grid electrode 180 and a first grid electrode line 181 extending from the first grid electrode 180.

The second electrode includes a second grid electrode 190 and a second grid electrode line 191 extending from the second grid electrode 190.

The first grid electrode line 181 fills the plurality of the first contact hole CH1, and the second grid electrode line 191 fills the plurality of the second contact hole CH2.

Here, the first grid electrode line 181 is connected to the first doping region 150 through the plurality of the first contact hole CH1, and the second grid electrode line 191 is connected to the second doping region 160 through the plurality of the second contact hole CH2.

The first grid electrode 180 connects at least two of the first grid electrode lines 181, and the second grid electrode 190 connects at least two of the second grid electrode lines 191.

The first grid electrode 180 and the second grid electrode 190 face each other and extend substantially perpendicular to a third direction d3.

The first grid electrode line 181 extends according to the third direction d3 forming an angle of about 45 degrees with at least one of the first direction d1 and the second direction d2.

The second grid electrode line 191 extends in the opposite direction to the third direction d3 and is substantially parallel to the first grid electrode line 181.

The first grid electrode line 181 and the second grid electrode line 191 extend with a substantially straight line shape.

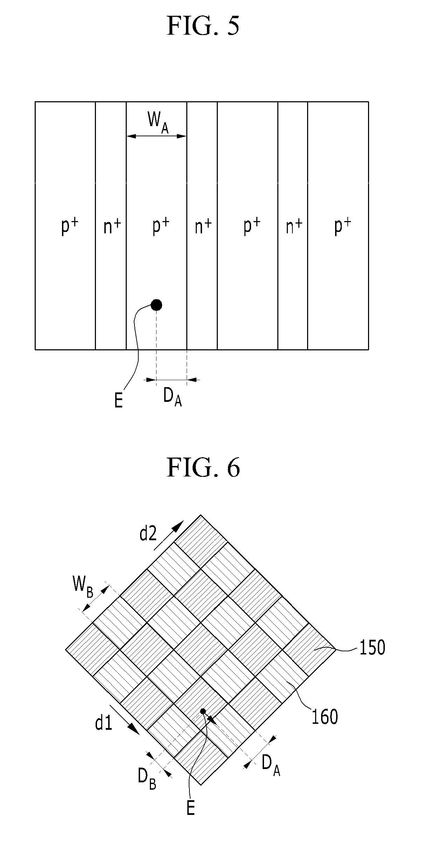

FIGS. 5 and 6 are top plan views to compare moving distances of a carrier according to a pattern structure of a doping region.

FIG. 5 shows a doping region having an n+ region and a p+ region with a stripe pattern in the surface of a wafer substrate.

The P+ region of the stripe pattern has a width W_{A}.

In the solar cell including the doping region having an n+ region and a p+ region with a stripe pattern in the surface of a wafer substrate, electron carriers generated by light may be moved by potential of the p+ region and the n+ region.

That is, an electron E denoted in FIG. 5 moves according to an arrow direction toward the n+ region, and the movement distance is denoted by D_{A}.

Here, an electron having a short lifetime is recombined before movement of the movement distance D_{A} such that it does not contribute to light efficiency.

FIG. 6 is a view showing an exemplary embodiment of a pattern structure of a doping region in a solar cell according to the present invention.

That is, the p+ region 150 (i.e., the first doping region) and the n+ region 160 (i.e., the second doping region) are alternately arranged with a lattice shape.

Here, the p+ region has a width W_{B} in the second direction d2.

In one exemplary embodiment, the width W_{B} in the second direction d2 may be equal to the width W_{B} of the first direction d1.

The electron E denoted in FIG. 6 must be moved into the n+ region.

Here, the carrier may be moved in one direction with a shortest distance when the solar cell includes the doping regions of the stripe pattern as shown in FIG. 5, however, in the exemplary embodiment according to the present invention, the carrier may be moved along the shortest distance D_{B} of the first direction d1 that is shorter than the distance D_{A} of the second direction d2 when the doping regions are alternately arranged with the lattice shape.

In other words, the movement distance of the carrier may be shortened in terms of probability in the exemplary embodiment that the doping regions are alternately arranged with the lattice shape compared with the stripe pattern such that the carrier having the short lifetime may be collected, and thereby a light efficiency may be substantially increased under a same light irradiation condition.

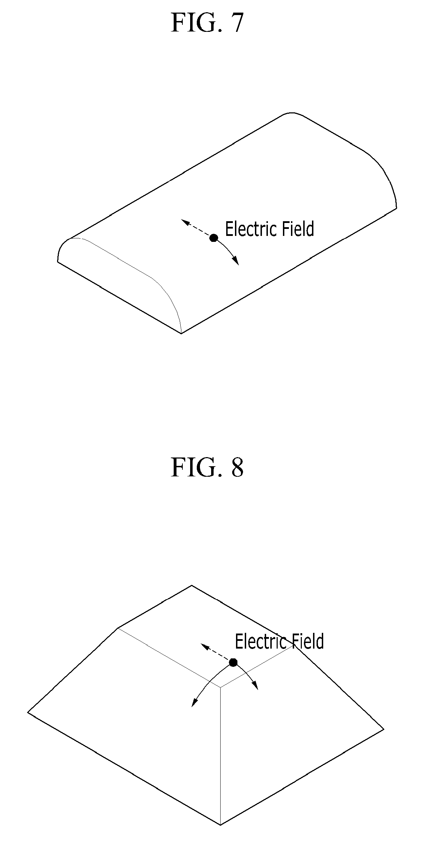

FIGS. 7 and 8 are band diagrams to compare an electric field applied to carriers according to a pattern structure of a doping region.

FIG. 7 shows an electric field applied to an electron carrier generated by the light in the case of having the pattern structure of FIG. 5, and FIG. 8 shows an electric field applied to an electron carrier generated by the light in the exemplary embodiment having the pattern structure of FIG. 6.

The electron carrier of FIG. 7 is operated by the electric field in one direction. However, the electron carrier of FIG. 8 receives the effect of the electric field in all directions such that effective carrier correction is further possible.

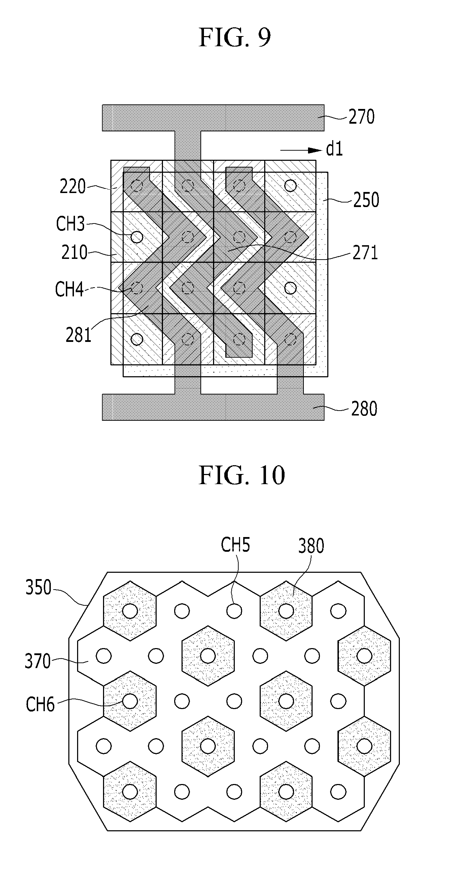

FIG. 9 is a top plan view showing another exemplary embodiment of an electrode structure in a solar cell according the present invention.

The exemplary embodiment of FIG. 9 is substantially the same as the exemplary embodiment described with reference to FIGS. 3 and 4.

However, a shape of grid electrode lines 271 and 281 connected to doping regions 210 and 220 through contact holes CH3 and CH4 formed in a passivation layer 250 is different from the shape of grid electrode lines of FIGS. 3 and 4.

The third grid electrode line 271 extends from a third grid electrode 270, and the fourth grid electrode line 281 extends from a fourth grid electrode 280.

The third grid electrode line 271 and the fourth grid electrode line 281 include a portion extending in a zigzag shape.

In the present exemplary embodiment, the third grid electrode 270 the and fourth grid electrode line 281 extend substantially parallel to the first direction d1 and the third doping region 210 and the fourth doping region 220 are alternately arranged, thereby forming a structure of the grid electrode lines 271 and 281 substantially similar to a zigzag shape.

FIG. 10 is a top plan view showing another exemplary embodiment of a pattern structure of a doping region in a solar cell according to the present invention.

Referring to FIG. 10, a sixth doping region 380 enclosed by a fifth doping region 370 and the fifth doping region 370 having a substantially wide area and formed with an island shape are positioned in a surface of the substrate.

A passivation layer 350 disposed on the fifth doping region 370 and the sixth doping region 380 is positioned on the substrate, and the passivation layer 350 has a plurality of fifth contact holes CH5 and a plurality of sixth contact holes CH6.

The plurality of fifth contact holes CH5 is formed at uniform intervals and is formed at positions corresponding to the fifth doping region 370, and the plurality of sixth contact holes CH6 is formed at uniform intervals and are formed at positions corresponding to the sixth doping region 380.

The fifth doping region 370 and a fifth grid electrode line (not shown) may be connected though the fifth contact hole CH5, and the sixth doping region 380 and a sixth grid electrode line (not shown) may be connected through the sixth contact hole CH6.

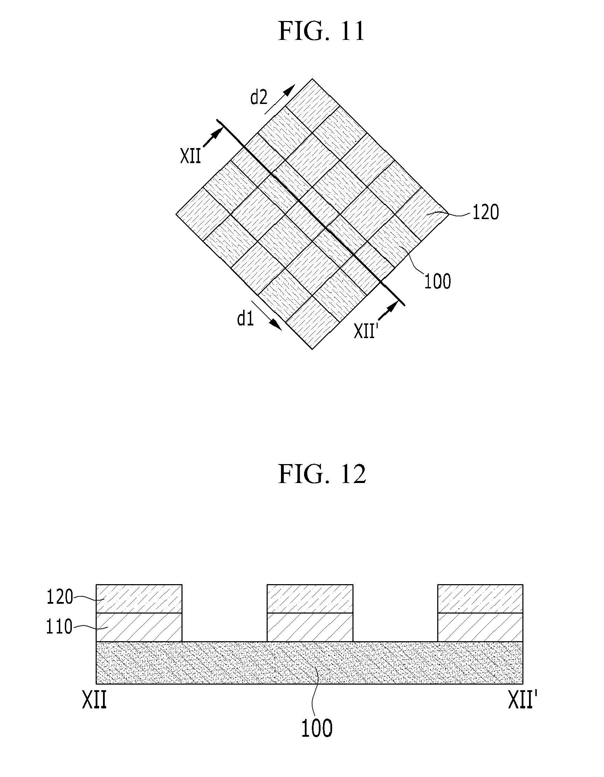

FIGS. 11 to 19 are plan views and cross-sectional views showing a manufacturing method of the exemplary embodiment of the solar cell of FIG. 1.

Referring to FIGS. 11 and 12, a first doping layer 110 is deposited on a substrate 100, and a diffusion preventing layer 120 is disposed on the first doping layer 110.

The first doping layer 110 and the diffusion preventing layer 120 are patterned to partially expose a surface of the substrate 100.

Here, a portion corresponding to the exposed surface of the substrate 100 and a portion of the remaining first doping layer 110 and diffusion preventing layer 120 that are not patterned are alternately arranged with a lattice shape in a plane view.

In one exemplary embodiment, the patterning of the first doping layer 110 and the diffusion preventing layer 120 may include at least one of a photolithography process, a screen printing process including an etching paste, or an inkjet printing process, for example, but is not limited thereto and may include various other processes.

In one exemplary embodiment, the first doping layer 110 may include a silicon oxide doped with the P-type impurity.

In one exemplary embodiment, the silicon oxide may be silicon dioxide (SiO2), for example.

In one exemplary embodiment, the P-type impurity may be boron (B), gallium (Ga), or indium (In), for example, but is not limited thereto and may include other materials with similar characteristics.

The substrate 100 includes a front side and a back side opposing the front side.

The first doping layer 110 is formed on the back side of the substrate 100.

The front side of the substrate 100 is a surface where light is absorbed from an outside.

In one exemplary embodiment, the diffusion preventing layer 120 may include the silicon oxide that is not doped.

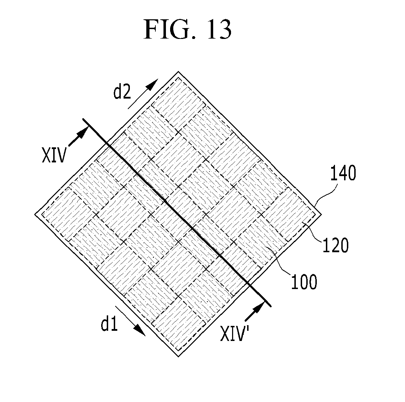

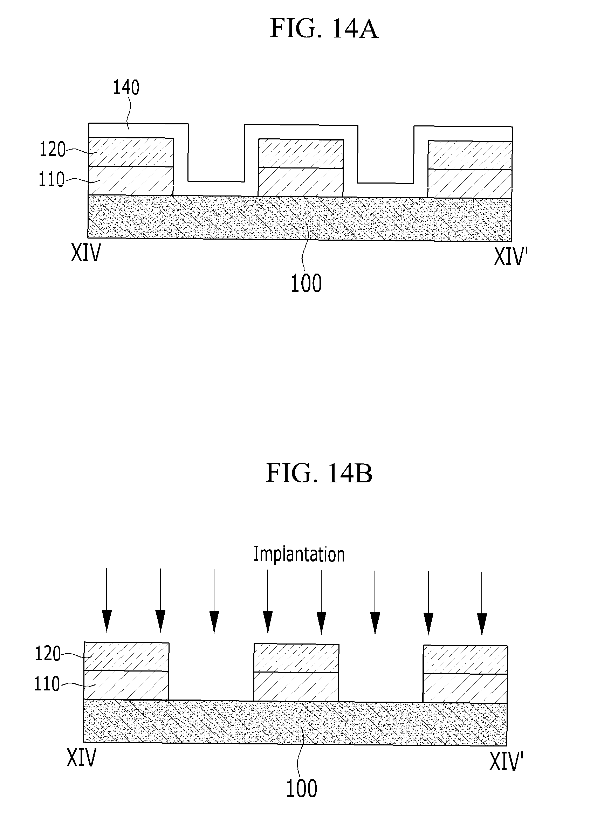

Referring to FIGS. 13 and 14A, a second doping layer 140 disposed on the exposed portion of the substrate 100 is disposed on the diffusion preventing layer 120.

The second doping layer 140 may include the silicon oxide doped with the N-type impurity.

In one exemplary embodiment, the silicon oxide may be silicon dioxide (SiO2), for example.

In one exemplary embodiment, the N-type impurity may be phosphorus (P), arsenic (As), or other materials with similar characteristics.

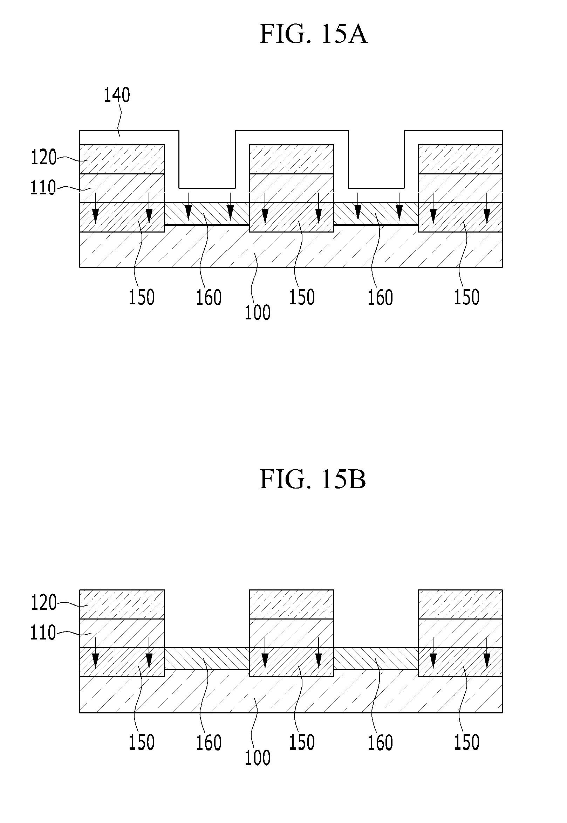

Referring to FIG. 15A, a heat treatment process is executed to diffuse an impurity from the first doping layer 110 such that a first doping region 150 is formed.

Here, the impurity is diffused from the second doping layer 140 contacting the substrate 100 such that a second doping region 160 is formed.

The first doping region 150 and the second doping region 160 may be substantially simultaneously formed.

Differently from FIGS. 13, 14A, and 15A, the second doping layer 140 may not be disposed, and impurity ions may be injected into the surface of the substrate 100 using the first doping layer 110 and the diffusion preventing layer 120 as a mask.

Referring to FIGS. 14B and 15B, the impurity ions are injected into the surface of the substrate 100 using the first doping layer 110 and the diffusion preventing layer 120 as a mask.

In one exemplary embodiment, the impurity ions may be phosphorus (P), arsenic (As), or other materials with similar characteristics.

Next, the heat treatment is executed to diffuse the impurity from the first doping layer 110 such that the first doping region 150 is formed, and the impurity injected to the substrate 100 through the ion injection method is activated by the heat treatment such that the second doping region 160 is formed.

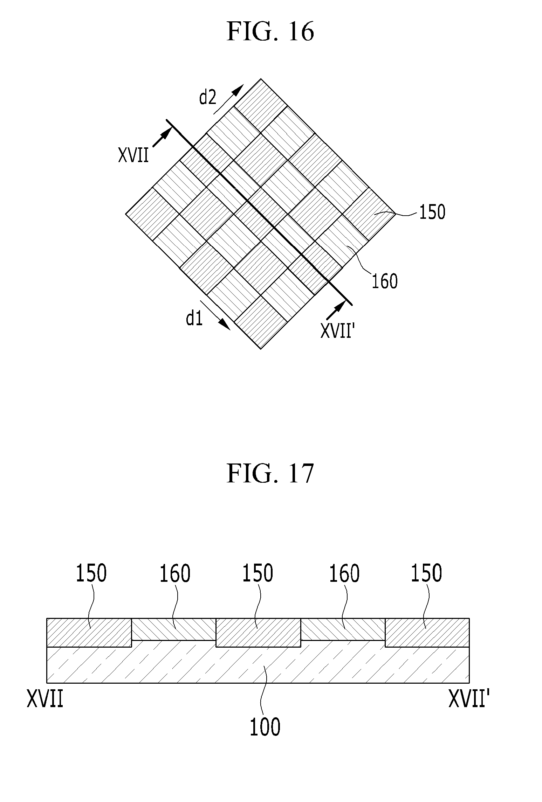

Referring to FIGS. 16 and 17, the first doping layer 110, the diffusion preventing layer 120, and the second doping layer 140 formed on the substrate 100 are removed.

In the present exemplary embodiment, the first doping layer 110, the diffusion preventing layer 120, and the second doping layer 140 may be etched using hydrogen fluoride (HF) having large etching selectivity for the substrate 100, for example, but is not limited thereto and may use various other methods.

The first doping region 150 and the second doping region 160 are alternately arranged with the grid pattern.

In detail, one first doping region 150 and one second doping region 160 that neighbor each other is referred to as a first unit, and the first unit is repeatedly arranged according to a second direction d2 as well as a first direction d1, where the first direction d1 and the second direction d2 are substantially perpendicular to each other.

In an exemplary embodiment of the solar cell manufactured according to the present invention, the first doping region 150 and the second doping region 160 form a PN conjunction.

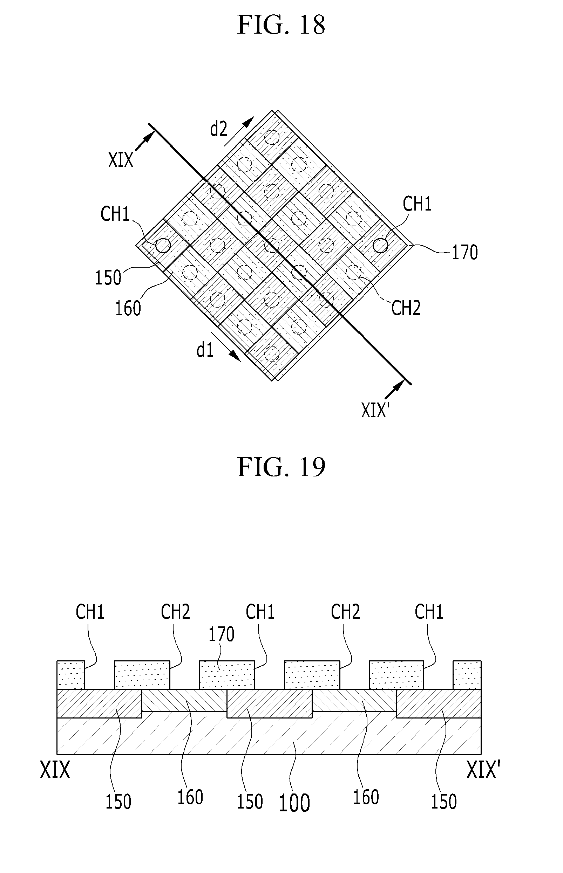

Referring to FIGS. 18 and 19, a passivation layer 170 having the first contact hole CH1 and the second contact hole CH2 is formed on the first doping region 150 and the second doping region 160, respectively.

Referring again to FIG. 3, the first electrode including the first grid electrode 180 and the first grid electrode line 181, and the second electrode including the second grid electrode 190 and the second grid electrode line 191, are formed on the passivation layer 170.

Here, the first grid electrode line 181 extends according to the third direction d3 with the straight line shape to be connected to the first doping region 150 through the first contact hole CH1.

Also, the second grid electrode line 191 extends according to the third direction d3 with the straight line shape to be connected to the second doping region 160 through the second contact hole CH2.

While this invention has been described in connection with what is presently considered to be practical exemplary embodiments, it is to be understood that the invention is not limited to the disclosed embodiments, but, on the contrary, is intended to cover various modifications and equivalent arrangements included within the spirit and scope of the appended claims.

## Claims

1. A solar cell comprising:
a substrate;
a first doping region and a second doping region positioned in a surface of the substrate; and
a passivation layer which is disposed on the first doping region and the second doping region, wherein the first doping region and the second doping region are alternately arranged in a grid pattern on the surface of the substrate.

2. The solar cell of claim 1, further comprising a first electrode and a second electrode disposed on the passivation layer.

3. The solar cell of claim 2, wherein the passivation layer includes a plurality of first contact holes and a plurality of second contact holes, the first electrode and the first doping region are connected to each other through the plurality of first contact holes, and the second electrode and the second doping region are connected to each other through the plurality of second contact holes.

4. The solar cell of claim 3, wherein the first doping region and the second doping region are alternately arranged according to a first direction and a second direction, respectively, and the first direction and the second direction are substantially perpendicular to each other.

5. The solar cell of claim 4, wherein
the first electrode extends with a straight line shape along a third direction, and the third direction forms an angle of about 45 degrees with at least one of the first direction and the second direction, respectively.

6. The solar cell of claim 4, wherein the first electrode and the second electrode respectively include a portion which extends with a zigzag shape.

7. The solar cell of claim 1, wherein the first doping region and the second doping region have a quadrangle shape from a top plane view.

8. The solar cell of claim 1, wherein
the substrate includes a front side and a back side, and the first doping region and the second doping region are disposed in the back side of the substrate.

9. The solar cell of claim 8, wherein light is absorbed through the front side of the substrate.

10. The solar cell of claim 1, wherein the first doping region and the second doping region include different types of conductive impurities.

11. A method for manufacturing a solar cell comprising:
disposing a first doping layer on a substrate;
disposing a diffusion preventing layer on the first doping layer;
patterning the first doping layer and the diffusion preventing layer to expose a portion of the substrate;
forming a second doping layer which is disposed on the exposed portion of the substrate on the diffusion preventing layer;
diffusing an impurity from the first doping layer to form a first doping region in a surface of the substrate; and
diffusing an impurity from the second doping layer to form a second doping region in the surface of the substrate surface,
wherein the exposed portion of the substrate formed by patterning the first doping layer and the diffusion preventing layer and a remaining portion of the first doping layer and the diffusion preventing layer which are not patterned are alternately arranged with a lattice shape, and
the first doping region and the second doping region are alternately arranged with the lattice shape.

12. The method of claim 11, wherein the diffusion of the impurity to form the first doping region and the second doping region comprises a heat treatment.

13. The method of claim 12, wherein the substrate includes a front side and a back side, and the first doping region and the second doping region are formed on the back side of the substrate.

14. The method of claim 13, further comprising:
removing the first doping layer, the diffusion preventing layer, and the second doping layer;
disposing a passivation layer which has a plurality of first contact holes and a plurality of second contact holes on the back side of the substrate; and
disposing a first electrode and a second electrode on the passivation layer, wherein the first electrode and the first doping region are connected to each other through the plurality of first contact holes, and the second electrode and the second doping region are connected to each other through the plurality of second contact holes.

15. The method of claim 14, wherein
the first doping region and the second doping region are alternately formed according to a first direction and a second direction, and the first direction and the second direction are substantially perpendicular to each other.
